# EUROPEAN PATENT SPECIFICATION

(11) **EP 0 343 970 B1**
(45) Date of publication and mention of the grant of the patent: **26.10.1994**
(21) Application number: 89305271.2
(22) Date of filing: 24.05.1989
(51) Int. Cl.: H01L 31/10

(54) **Planar type heterojunction avalanche photodiode**
Heteroübergang-Lawinen-Photodiode vom planaren Typ
Photodiode à avalanche à hétérojonction du type planaire

(30) Priority: 24.05.1988 JP 127821/88
(43) Date of publication of application: 29.11.1989
(73) Proprietor: NEC CORPORATION, Tokyo (JP)
(72) Inventor: Torikai, Toshitaka, Minato-ku Tokyo (JP)
(74) Representative: Goodman, Simon John Nye

(56) References cited:
- EP-A- 0 145 316
- EP-A- 0 242 298
- EP-A- 0 325 532
- FR-A- 2 252 653
- US-A- 4 212 019
- IEEE TRANSACTIONS ON ELECTRON DEVICES, vol. ED-34, no. 11, November 1987, pp. 2265-2269 ; G.-C. CHI et al.: "Planar InP/InGaAsP three-dimensional graded-junction avalanche photodiode"

## Description

### Field of the invention

The invention relates to a planar type heterojunction avalanche photodiode, and more particularly to an avalanche photodiode which is used for a photodetector having a wide bandwidth and a high sensitivety in optical communication systems etc.

### Background of the invention

One type of a planar type heterojunction avalanche photodiode is disclosed in the U.S. Patent No. 4,651,187. In the planar type heterojunction avalanche photodiode, an n-InP buffer layer, an n⁻-In_{0.53}Ga_{0.47}As light absorbing layer, an n-InGaAsP intermediate band-gap layer, an n-InP avalanche multiplication layer, and an n⁻-InP cap layer are successively provided on an n-InP substrate. Further, a p⁺-InP region is preferentially provided in the avalanche multiplication layer and the cap layer, and the p⁺-InP region is surrounded at its outer periphery by a p⁻-InP guard ring region. A p-ring shaped electrode and an anti-reflection film are provided on the top surface of the cap layer and the p⁺-InP region, and an n-electrode is provided on the back surface of the substrate.

In operation, a reverse bias voltage is applied across the p-and n-electrodes, and light is supplied to the top surface of the anti-reflection film. Thus, electron and hole carriers are excited in the light absorbing layer, so that hole carriers are injected into the avalanche multiplication layer to result in carrier multiplication.

In the avalanche photodiode of a top surface illumination type as described above, a wide bandwidth characteristic is obtained in a case where the light absorbing layer, the intermediate band-gap layer, and the avalanche multiplication layer become thin in total thickness to shorten a carrier transit time, during which carriers produced in the light excitation and the light multiplication transit through the three layers. In this respect, the light absorbing layer and the avalanche multiplication layer are desired to be thinner because the intermediate band-gap layer is originally thin, that is, a carrier transit time is negligible in the intermediate band-gap layer. The wide bandwidth characteristic is further obtained in a case where an area of the p⁺-InP region and the p⁻-InP guard ring becomes small to lower a junction capacitance.

In the planar type heterojunction avalanche photodiode, however, there is a disadvantage that the sensitivity is deteriorated because the quantum efficiency is lowered, when the light absorbing layer is made thin to shorter the aforementioned carrier transit time. There is a further disadvantage that a predetermined reduction of a junction capacitance is difficult even if an area of the p-ring shaped electrode becomes small, because a lead wire electrode pad is provided to connect a lead wire electrically to the p-ring shaped electrode. The reduction of the junction area is also difficult, because the light supplying surface and the lead wire electrode pad are positioned on the common top surface of the avalanche photodiode.

A planar heterojunction avalanche photodiode (APD) is described in IEEE Transactions on Electron Devices, ED-34, No. 11, November 1987, pages 2265 to 2269. This document describes a back-illuminated planar APD. An anti-reflection layer is applied to the base of the substrate and an opening is provided in the n-electrode on the base of the substrate through which the APD is illuminated. The p-electrode is formed of a layer of chromium overlaid by a layer of gold, both applied by e-beam evaporation.

### Summary of the invention

Accordingly, it is an object of the invention to provide a planar type heterojunction avalanche photodiode having a wide bandwidth and a high sensitivity, for instance, in optical communication systems.

According to the invention, a planar type heterojunction avalanche photodiode is provided comprising;
a light absorbing layer of a first conduction type and a predetermined band-gap energy provided on a side of a substrate of the first conduction type,
an avalanche multiplication layer of the first conduction type and a band-gap energy wider than the predetermined band-gap energy provided on a side of the light absorbing layer opposite to the substrate,
a conduction region of a second conduction type in contact with the avalanche multiplication layer on a side opposite to said light absorbing layer,
a high reflection region provided on a side of the conduction region opposite to the avalanche multiplication layer,
an anti-reflection film provided on a side of the substrate opposite to the light absorbing layer, said anti-reflection film facing said high reflection region, and
p- and n-electrodes respectively connected to the conduction region and the substrate;
characterised in that the high reflection region comprises a dielectric film located on said conduction region, said dielectric film having an optical thickness of (2m-1)λ/4, where m is a positive integer and λ is a wavelength of light supplied to said anti-reflection film in operation of the photodiode, and a metal film on a side of the dielectric film opposite to the conduction region.

### Brief description of drawings

The invention will be explained in more detail in conjunction with appended drawings wherein,
Fig. 1 is a cutaway cross sectional view illustrating a conventional planar type heterojunction avalanche photodiode which is vertically divided to show its cross section,
Fig. 2 is a cutaway cross sectional view illustrating a planar type heterojunction avalanche photodiode, which is vertically divided to show its cross section, in an embodiment according to the invention,
Fig. 3 is a cutawawy cross sectional view illustrating a planar type heterojunction avalanche photodiode of Fig. 2 which is provided on a support, and
Fig. 4 is a graphical diagram explaining a relation between a thickness of a light absorbing layer and a bandwidth- quantum efficiency product in the planar type heterojunction avalanche photodiode of Fig. 2.

### Description of preferred embodiments

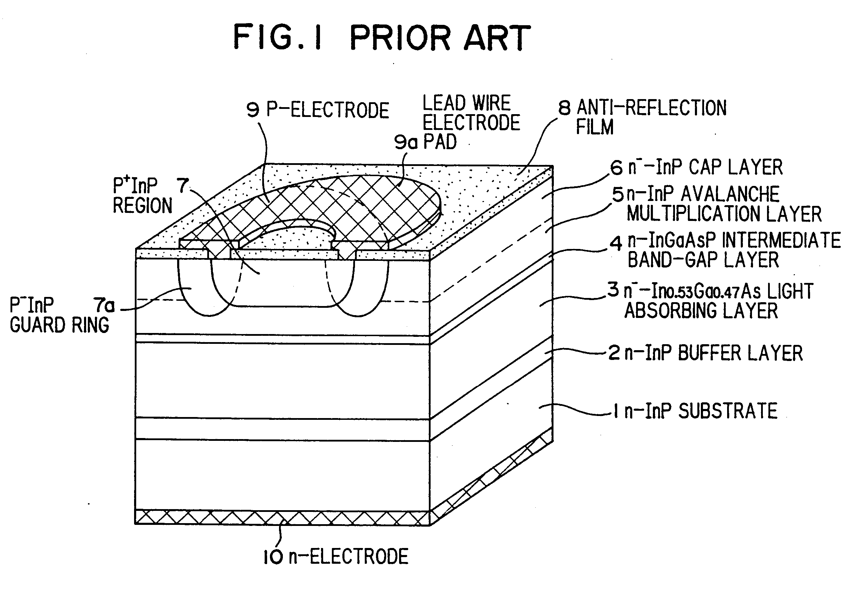

Before explaining a planar type heterojunction avalanche photodiode in an embodiment according to the invention, the aforementioned conventional planar type heterojunction avalanche photodiode will be explained in Fig. 1. The conventional planar type heterojunction avalanche photodiode comprises an n-InP substrate 1, an n-InP buffer layer 2, an n⁻-In_{0.53}Ga_{0.47}As light absorbing layer 3, an n-InGaAsP intermediate band-gap layer 4, an n-InP avalanche multiplication layer 5, and an n⁻-InP cap layer 6. The conventional planar type heterojunction avalanche photodiode further comprises a p⁺-InP region 7 preferentially provided in the cap layer 6 and the avalanche multiplication layer 5 to form p⁺n junction front, a p⁻-InP guard ring region 7a surrounding the outer periphery of the InP region 7, an anti-reflection film 8 provided on the top surface of the cap layer 6, a p-ring shaped electrode 9 connected through a hole of the anti-reflection film 8 to the InP region 7, a lead wire electrode pad 9a for connecting a lead wire electrically to the p- ring shaped electrode 9 and having an area of 7 x 10⁻⁶ to 2 x 10⁻⁵cm² which is a minimum value, and an n-electrode 10 provided on the back surface of the substrate 1. In the conventional planar type heterojunction avalanche photodiode, a thickness of the intermediate band-gap layer 4 is as thin as 0.1 to 0.3µm, so that a carrier transit time is negligible in the intermediate band-gap layer 4. On the contrary, a thickness of the light absorbing layer 3 is 2 to 5 µ m, and that of the avalanche multiplication layer 5 is 1 to 2µm. Therefore, a carrier transit time is desired to be shortened as described before. Operation and other disadvantages of the conventional planar type heterojunction avalanche photodiode are not explained here.

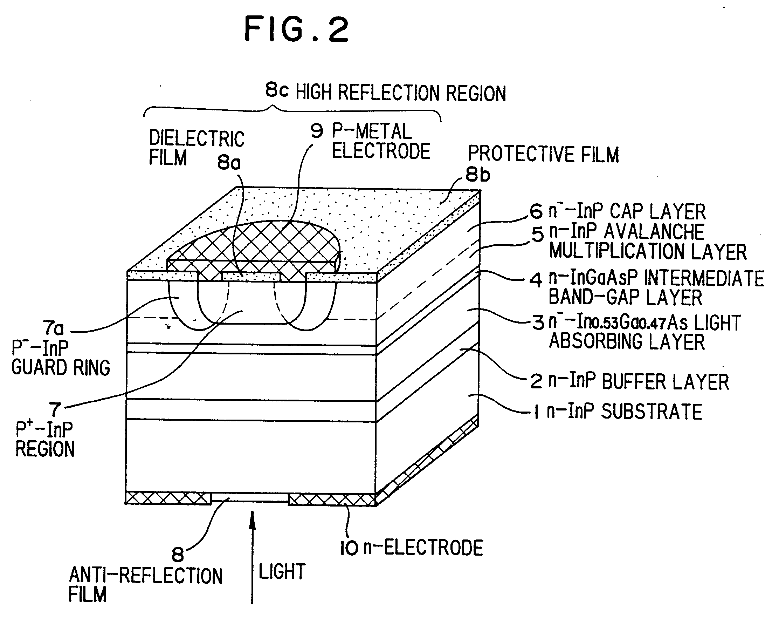

Next, a planar type heterojunction avalanche photodiode in an embodiment according to the invention will be explained in Fig. 2, wherein like parts are indicated by like reference numerals of Fig. 1. In the planar type heterojunction avalanche photodiode, a thickness of an n⁻-In_{0.53}Ga_{0.47}As light absorbing layer 3 is 1.5 to 2.0 µ m which is half the thickness of the conventional planar type heterojunction avalanche photodiode, and those of an n-InGaAsP intermediate band-gap layer 4 and an n-InP avalanche multiplication layer 5 are 0.4µm, and 0.5 to 0.8µm, respectively, wherein the light absorbing layer 3 can receive light having a wavelength of up to 1.65µm, and the intermediate band-gap layer 4 and the avalanche multiplication layer 5 have band-gap energies corresponding to wavelengths of 1.15µm and 0.93µm, respectively. Further, an anti-reflection film 8 is preferentially provided on the back surface of an n-InP substrate 1, such that the anti-reflection film 8 is positioned to face a p⁺-InP region 7, and a dielectric film 8a having a thickness of (2m-1)λ /4 is provided on the surface of the p⁺-InP region 7, where λ is a wavelength of light supplied to the anti-reflection film 8, and m is a positive integer (m=1, 2, 3 .... ). Still further, a p-circular metal electrode 9 is provided to consitute a high reflection region 8c in cooperation with the dielectric film 8a.

In operation, a reverse bias voltage is applied across the p- and n-electrodes 9 and 10, and light having a wavelength of 1.55µm is illuminated to the anti-reflection film 8, so that light is passed through the substrate 1 and the buffer layer 2 to the light absorbing layer which is thinner compared to the conventional one. The light is mostly absorbed in the light absorbing layer 3, however the fraction of the light is passed to the high reflection region 8c, and then reflected therefrom back to the light absorbing layer 3. Accordingly, the light is tolally absorbed in the light absorbing layer 3 to provide a sufficient high quantum efficiency.

In this embodiment, the p-electrode 9 can be circular and combined with the lead wire electrode pad, because the anti-reflection film 8 can be separated on the back surface of the avalanche photodiode. This avoids the necessity of providing the additional lead wire electrode pad 9a, so that a junction area can be smaller to provide a smaller junction capacitance. Consequently, a wide bandwidth characteristic is obtained in the planar type heterojunction avalanche photodiode.

A planar type heterojunction avalanche photodiode according to the invention is fabricated in a following process.

On an n⁺-InP substrate 1 doped with Sulfer, an n-InP buffer layer 2 having a thickness of approximately 1µm, an n⁻-In_{0.53}Ga_{0.47}As light absorbing layer 3 having a thickness of 1.5 to 2.0µm and a carrier concentration of 2 to 5 x 10¹⁵cm⁻³, an n-InGaAsP intermediate band-gap layer 4 having a thickness of approximately 0.4µm, an n-InP avalanche multiplication layer 5 having a thickness of 0.5 to 0.8µm and a carrier concentration of 5 to 7 x 10¹⁶cm⁻³, and an n⁻-InP cap layer 6 having a thickness of 1.5 to 2.0µm and a carrier concentration of 1 to 5 x 10¹⁵cm⁻³ are successively grown at a temperature of 700°C by a hydride vapor phase epitaxy. The n-InP buffer layer 2 is a layer for avoiding the penetration of defects and dislocations in the InP substrate 1 into the layers 3 to 6, the n⁻-In_{0.5}Ga_{0.47}As light absorbing layer 3 is a layer for absorbing light having a wavelength of 1 to 1.65µm to generate electron and hole carrier pairs, and the n-InPGaAsP intermediate band-gap layer 4 is a layer for avoiding the trap of holes due to the Valence band offset between the light absorbing layer 3 and the avalanche multiplication layer 5.

After the growth of the layer structure in the vapor phase epitaxy as described above, a guard ring region 7a is formed by implanting Be ions into the cap layer 6 and the avalanche multiplication layer 5. That is, a SiO₂ film of a thickness of approximately 1µm is deposited on the cap layer 6 at a temperature of 360°C by a thermal CVD method. The SiO₂ film is preferentially removed in the use of buffered hydrofluoric acid by means of a light exposure mask which has a pattern of a ring drawn by an ordinal light exposure method, and Be ions are injected through a removed portion of the SiO₂ film with an dose of 5 x 10¹³cm⁻² under an accelerating voltage range of 100 to 140 KV. Then, the remaining SiO₂ film is totally removed by use of hydrofluoric acid liquid, and a PSG film having a thickness of approximately 100µm is deposited at a temperature of 360°C by the thermal CVD method. Thereafter, a heat treatement of 700°C is performed for an activation and a Drive-in diffusion of the injected Be ions for twenty minutes, thereby providing the guard ring region 7a. After that, the PSG film is preferentially removed at a portion corresponding to the inside of the guard ring region 7a to form a circular aperture by use of a light exposure mask, and Zn is thermally diffused through the circular removed portion of the PSG film into the cap layer 6 and the avalanche multiplication layer 5 at a temperature of 530°C for fifteen to twenty minutes, thereby forming the p⁺-conduction region 7 to provide a pn junction front. Next, the PSG film is removed by use of hydrofluoric acid and a SiN film having a thickness of approximately 180nm is deposited on the cap layer 6 at a temperature of 300°C by a plasma enhanced CVD method. The SiN film thus deposited is preferentially removed with a pattern of a ring on the p⁺-conduction region 7 by an ordinary light exposure method, such that the inside region of the removed ring portion is for a dielectric film 8a of a high reflection region 8c, and the outside region thereof is for a protective film 8b. Then, a p-circular metal electrode 9 of a Ti/Pt/Au multi-layer film is provided on the SiN film and the exposed p⁺-InP conduction region 7 by an electron bombardment evaporation. On the other hand, the back surface of the substrate 1 is polished to provide a mirror surface on which a SiN film is formed at a temperature of 200°C by a plasma CVD method. The SiN film is removed except for a region of an anti-reflection film 8 facing the high reflection region 8c. Finally, an n-metal electrode 10 of a AuGe/Ni layer is provided on the removed portion of the SiN film on the back surface of the substrate 1 by a resistance heating evaporation, thereby completing a planar type heterojunction avalanche photodiode according to the invention.

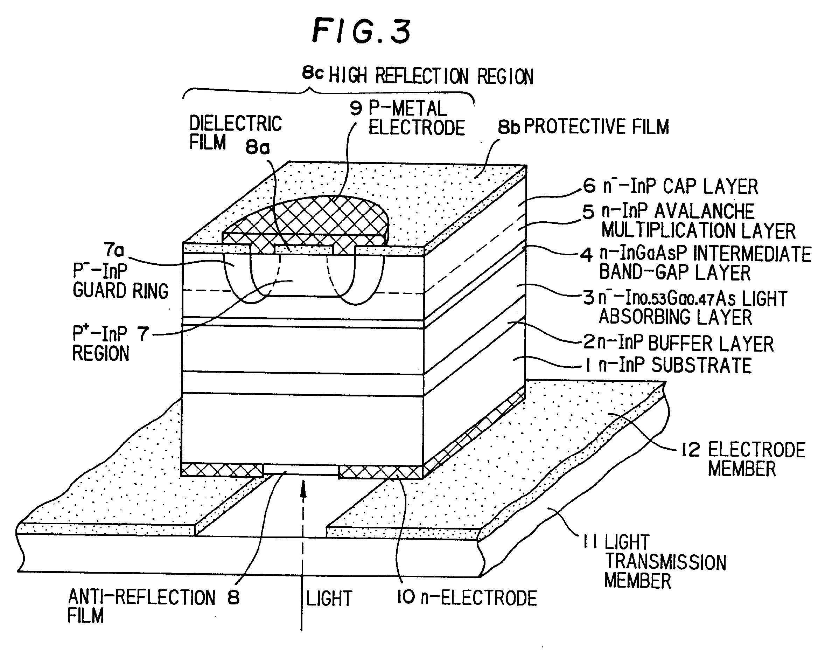

The planar type heterojunction avalanche photodiode (thus) fabricated is mounted on a support including a sapphire support 11 having a thickness of approximately 300µm and a preferential metal electrode 12 of a Ti/Pt/Au multi-layer as shown in Fig. 3, so that it is easy to supply light to the anti-reflection film 8, even if the anti-reflection film 8 is positioned on the back surface of the substrate 1. The sapphire support 11 is selected for a support material, because an absorbing loss is low at a wavelength of 1 to 2 µ m, and a light transmission characteristic is flat.

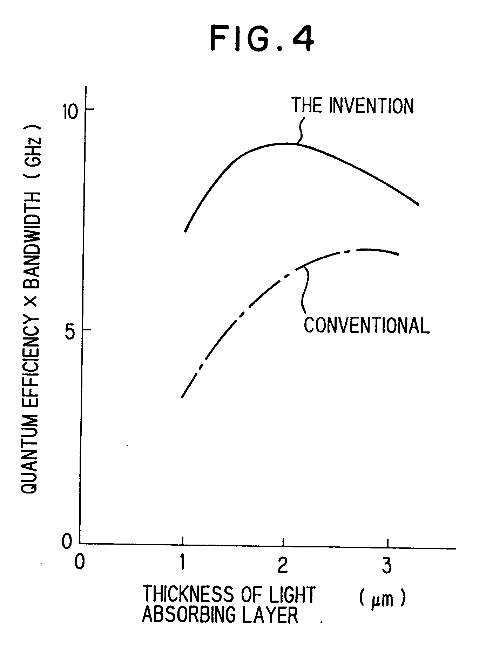

In the structure as shown in Fig. 2 or Fig. 3, a bandwidth-quantum efficiency product is measured relative to a thickness of the light absorbing layer 3 as shown in Fig. 4. The bandwidth-quantum efficiency product is appropriate as a figure of merit from which a wide bandwidth characteristic and a high sensitivity characteristic of a planar type heterojunction avalanche photodiode are judged. As clearly understood from the result of Fig. 4 in which a multiplication factor is five, the bandwidth-quantum efficiency product is much improved in a thickness of the light absorbing layer 3 ranging 1 to 3µm as compared to the conventional planar type heterojunction avalanche photodiode.

## Claims

1. A planar type heterojunction avalanche photodiode: comprising;
a light absorbing layer (3) of a first conduction type and a predetermined band-gap energy provided on a side of a substrate (1) of the first conduction type,
an avalanche multiplication layer (5) of said first conduction type and a band-gap energy wider than the predetermined band-gap energy provided on a side of the light absorbing layer opposite to the substrate,
a conduction region (7) of a second conduction type in contact with the avalanche multiplication layer on a side opposite to said light absorbing layer,
a high reflection region (8c) provided on a side of said conduction region opposite to the avalanche multiplication layer,
an anti-reflection film (8) provided on a side of the substrate opposite to the light absorbing layer, said anti-reflection film facing said high reflection region, and
p- and n-electrodes (9), (10) respectively connected to said conduction region and said substrate;
characterised in that said high reflection region comprises a dielectric film (8a) located on said conduction region, said dielectric film having an optical thickness of (2m-1)λ/4, where m is a positive integer and λ is a wavelength of light supplied to said anti-reflection film in operation of the photodiode, and a metal film (9) on a side of said dielectric film opposite to said conduction region.

2. A photodiode according to claim 1, in which the metal film is a part of said p-electrode.

3. A photodiode according to claim 1 or 2, in which said p-electrode is circular and forms part of said high reflection région.

## Patentansprüche

1. Heteroübergang-Lawinen-Photodiode vom planaren Typ mit:
einer lichtabsorbierenden Schicht (3) eines ersten Leitungstyps und mit einer bestimmten Bandabstandsenergie, die auf einer Seite eines Substrats (1) des ersten Leitungstyps vorgesehen ist,
eine Lawinenmultiplikationsschicht (5) des ersten Leitungstyps und mit einer Bandabstandsenergie, die größer ist als die bestimmte Bandabstandsenergie, die auf einer Seite der lichtabsorbierenden Schicht gegenüber dem Substrat vorgesehen ist,
einem Leitungsbereich (7) eines zweiten Leitungstyps in Berührung mit der Lawinenmultiplikationsschicht auf einer Seite gegenüber der lichtabsorbierenden Schicht, einem hochreflektierenden Bereich (8c) , der auf einer Seite des Leitungsbereichs gegenüber der Lawinenmultiplikationsschicht vorgesehen ist,
ein Antireflektionsfilm (8), der auf einer Seite des Substrats gegenüber der lichtabsorbierenden Schicht vorgesehen ist, wobei der Antireflektionsfilm dem hochreflektierenden Bereich gegenüber liegt, und
p- und n-Elektroden (9), (10), die mit dem Leitungsbereich bzw. dem Substrat verbunden sind,
dadurch gekennzeichnet, daß der hochreflektierende Bereich einen auf dem Leitungsbereich vorgesehenen dielektrischen Film (8a) aufweist, wobei der dielektrische Film eine optische Dicke von (2m-1)λ/4 hat, wobei m eine positive ganze Zahl ist und λ eine Wellenlänge des Lichts ist, das beim Betrieb der Photodiode an den antireflektierenden Film geliefert wird, und einen Metallfilm (9) auf einer Seite des dielektrischen Films gegenüber dem Leitungsbereich.

2. Photodiode nach Anspruch 1, wobei der Metallfilm ein Teil der p-Elektrode ist.

3. Photodiode nach Anspruch 1 oder 2, wobei die p-Elektrode kreisförmig ist und einen Teil des hochreflektierenden Bereiches bildet.

## Revendications

1. Photodiode à avalanche à hétérojonction du type planar comprenant,
une couche absorbant la lumière (3) d'un premier type de conduction et d'énergie de bande interdite prédéterminée placée sur un côté du substrat (1) du premier type de conduction,
une couche de multiplication par avalanche (5) dudit premier type de conduction et d'une énergie de bande interdite plus grande que l'énergie de bande interdite prédéterminée placée sur un côté de la couche absorbant la lumière opposée au substrat,
une région de conduction (7) d'un second type de conduction en contact avec la couche de multiplication par avalanche sur le côté opposé à ladite couche absorbant la lumière,
une région à haute réflexion 8c prévue sur un côté de ladite région de conduction opposée à la couche de multiplication par avalanche,
un film anti-réfléchissant (8) placé sur un côté du substrat opposé à la couche absorbant la lumière, ledit film anti-réfléchissant étant en regard de ladite région à haute réflexion, et
les électrodes p et n (9), (10) respectivement connectées à ladite région de conduction et audit substrat,
caractérisé en ce que ladite région à haute réflexion comprend un film diélectrique (8a) placé sur ladite région de conduction, ledit film diélectrique ayant une épaisseur optique de (2m-1)λ/4 où m est un nombre entier positif et λ est la longueur d'onde de la lumière délivrée audit film anti-réfléchissant pendant le fonctionnement de la photodiode et un film métallique (9) sur un côté dudit film diélectrique opposé à ladite région de conduction.

2. Photodiode selon la revendication 1, dans laquelle le film métallique et une partie de ladite électrode p.

3. Photodiode selon la revendication 1 ou 2, dans laquelle ladite électrode p est circulaire et constitue une partie de ladite région à haute réflexion.
